# EUROPEAN PATENT APPLICATION

(11) **EP 2 878 524 A1**
(43) Date of publication of application: **03.06.2015**
(21) Application number: 13196922.2
(22) Date of filing: 12.12.2013
(51) Int. Cl.: B62J 11/00

(54) **Human machine interface of electric bicycle**

(30) Priority: 27.11.2013 KR 20130145587
(71) Applicant: Mando Corporation, Pyeongtaek-si, Gyeonggi-do (KR)
(72) Inventor: Cho, Seong Jong, Gyeonggi-do (KR); Kim, Ho Sik, Seoul (KR)
(74) Representative: Hirsch & Associés

(57) **Abstract**

Disclosed is a human machine interface of an electric bicycle. The human machine interface includes a stand (51) electrically connected to an electronic controller of the electric bicycle, the stand including a plurality of first contact point pairs (56), and an interface body (60) slidably coupled to the stand, the interface body including a plurality of second contact point pairs (66) electrically connected to the first contact point pairs, wherein the first contact points or the second contact points are arranged so as to deviate from a sliding direction.

## Description

### BACKGROUND

### 1. Field

Embodiments of the present invention relate to a human machine interface that controls an electric bicycle and an installation structure of the human machine interface.

### 2. Description of the Related Art

A bicycle is basically configured such that a user pedals the bicycle and force generated as the result thereof is transmitted to a wheel via a chain to move the bicycle. However, the chain has a complicated structure and occupies a large area of the bicycle. Furthermore, the chain may be separated from the wheel or clothes of a rider may be caught in the chain.

In recent years, chainless electric bicycles have been developed and used.

Korean Patent Application Publication No. 10-2012-0001834 (published on January 5, 2012) discloses a chainless electric bicycle which has been filed in the name of the applicant of the present application. The electric bicycle includes a motor to rotate wheels, a battery to supply power to the motor, and an electronic controller to control the motor and the battery. When power is supplied to the motor under control of the electronic controller, the motor rotates the wheels. In addition, the above patent literature discloses a generator to generate electricity according to driving of pedals. The electronic controller compares speed of the generator with that of the motor to selectively increase or decrease load of the pedals, thereby realizing pedal feeling in which a rider may feel as if there were a chain.

However, the above electric bicycle realizes the pedal feeling based only on information operated by the electronic controller. As a result, a user may not actively control the pedal feeling. Furthermore, the user may not concretely check a battery level, traveling speed, pedal feeling, etc. of the electric bicycle.

### SUMMARY

It is an aspect of the present invention to provide an electric bicycle including a human machine interface to enable a user to actively realize pedal feeling wherein the human machine interface is easily mounted to the electric bicycle and easily operated.

Additional aspects of the invention will be set forth in part in the description which follows and, in part, will be obvious from the description, or may be learned by practice of the invention.

In accordance with one aspect of the present invention, a human machine interface of an electric bicycle includes a stand electrically connected to an electronic controller of the electric bicycle, the stand including a plurality of first contact point pairs, and an interface body slidably coupled to the stand, the interface body including a plurality of second contact point pairs electrically connected to the first contact point pairs, wherein the first contact points or the second contact points are arranged so as to deviate from a sliding direction.

The first contact point pairs or the second contact point pairs may be opposite to each other with respect to a virtual line extending in the sliding direction.

The first contact points or the second contact points may be arranged at an inclination to the sliding direction.

The stand may be provided at a top thereof with a first holder and the interface body may be provided at a bottom thereof with a second holder coupling to the first holder in the sliding direction.

A waterproofing well may be provided in front of the second contact points.

The waterproofing well may be provided to cover a front and side of the stand.

### BRIEF DESCRIPTION OF THE DRAWINGS

These and/or other aspects of the invention will become apparent and more readily appreciated from the following description of the embodiments, taken in conjunction with the accompanying drawings of which:
FIG. 1 is a perspective view showing an electric bicycle according to an embodiment of the present invention;
FIG. 2 is a perspective view showing a screen of a human machine interface of an electric bicycle according to an embodiment of the present invention;
FIG. 3 is a perspective view showing the human machine interface of the electric bicycle according to the embodiment of the present invention;
FIG. 4 is a perspective view showing a stand of the human machine interface of the electric bicycle according to the embodiment of the present invention; and
FIG. 5 is a block diagram showing electrical connection between the human machine interface of the electric bicycle according to the embodiment of the present invention and an electronic controller.

### DETAILED DESCRIPTION

Now, preferred embodiments of the present invention will be described in detail with reference to the annexed drawings. The preferred embodiments described in the following specification and shown in the accompanying drawings are illustrative only and are not intended to represent all aspects of the invention, so that it is to be understood that various equivalents and modifications can be made without departing from the spirit of the invention. In the drawings, elements unrelated to the embodiments of the present invention are omitted from depiction for clarity, and the component's width, length, thickness, etc. are exaggerated for convenience. Like numbers refer to like elements throughout the description of the figures.

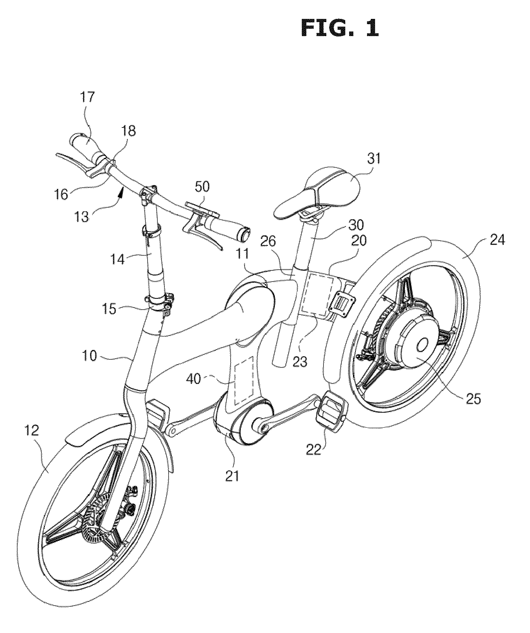

FIG. 1 is a perspective view showing an electric bicycle according to an embodiment of the present invention.

Referring to FIG. 1, the electric bicycle includes a front frame 10, a rear frame 20, and a saddle frame 30.

The front frame 10 and the rear frame 20 are coupled to a hinge plate 11, which is shaft-coupled to a hinge shaft such that the hinge plate 11 is rotated about the hinge shaft backward and forward.

A handle stay 14, to which a front wheel 12 and a handle unit 13 are connected, is coupled to one end of the front frame 10.

The handle unit 13 includes a handle stem 15 coupled to the lower end of the handle stay 14, a handle bar 16 coupled to the handle stay 14, a handle grip mounted at the handle bar 16, and a throttle 18 to allow input of a user's acceleration command.

The handle stem 15 is provided to adjust the height of the handle unit 13 and the handle bar 16 is provided to adjust the direction of the bicycle. A human machine interface 50 to display a state of the electric bicycle to a rider and to transmit a rider's demand to an electronic controller 40 via a button is mounted at the handle grip 17. The human machine interface 50 is electrically connected to the electronic controller 40. The throttle 18 may be formed in the shape of a lever which may be manipulated by the user. The throttle 18 outputs a signal indicating a rotation degree of the throttle 18 according to user's manipulation. The throttle may sense an opening degree of a throttle valve provided therein and output a signal corresponding thereto in the same manner as a general throttle.

The front wheel 12 is rotatably coupled to one side of the lower end of the handle stay 14. In this embodiment, the front wheel 12 may be coupled to the right side of the lower end of the handle stay 14 when viewed from the rear of the electric bicycle. Although not shown, the front wheel 12 may be coupled to a fork-type handle stay 14 of a general bicycle.

A generator 21 is mounted at one end of the rear frame 20. Pedals 22 are rotatably connected to opposite sides of the generator 21. When the rider rotates the pedals 22, the generator 21 converts rotational force of the pedals 22 into electrical energy, which may be stored in a battery 23. The electronic controller 40 is located above the generator 21.

A rear wheel 24 is rotatably coupled to the left side of one end of the rear frame 20. Although not shown, the rear wheel 24 may be coupled to a fork-type rear frame 20 of a general bicycle.

A motor 25 to rotate the rear wheel 24 such that the bicycle moves forward is mounted at the rear wheel 24. A gearbox to change rotational speed of the rear wheel 24 according to user manipulation of the human machine interface 50 may be mounted at the motor 25.

In addition, the battery 23, which stores electrical energy converted by the generator 21, may be mounted in the rear frame 20. Alternatively, the battery 23 may be mounted in the front frame 10.

One side of the rear frame 20 is coupled to the rear of a head tube 26. The rear frame 20 and the head tube 25 may be integrated.

The saddle frame 30 is provided on the rear frame 20. A saddle 31, on which the rider sits, is mounted at one end of the saddle frame 30.

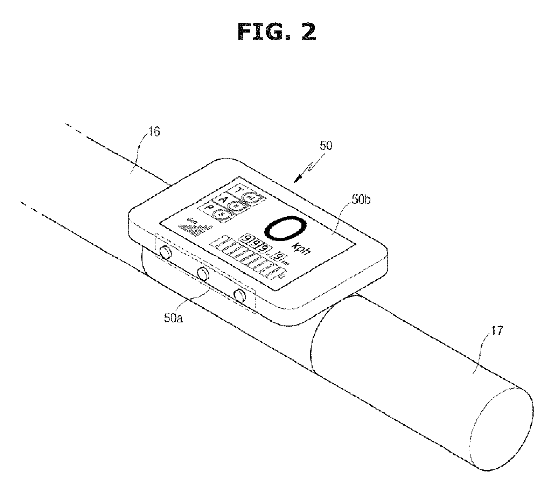

FIG. 2 is a perspective view showing a human machine interface of an electric bicycle according to an embodiment of the present invention.

Referring to FIG. 2, the human machine interface 50 includes mode switches 50a to adjust pedal force of the pedals 22 and a display 50b to display the pedal force of the pedals 22 according to manipulation of the mode switches 50a and a battery level of the battery 23 to the user.

The mode switches 50a are provided to select a pedal feeling mode, an acceleration feeling mode, and a speed change mode. The mode switches 50a are mounted one side of the human machine interface 50 such that sub modes of a selected mode may be selected.

The display 50b may display modes, such as a pedal feeling mode, an acceleration feeling mode, and a speed change modes, an amount of electric power generated by the generator, battery level of the battery, a movement distance, traveling speed, etc. Information necessary for display is transmitted from the electronic controller 40 electrically connected to the human machine interface 50.

The human machine interface 50, which includes the mode switches 50a and the display 50b, may be provided at a connection between the handle bar 16 and the handle grip 17. In this embodiment, the electronic controller 40 is provided at the pedal side (see FIG. 1). Consequently, the human machine interface 50 is electrically connected to the electronic controller 40 via a cable (not shown) extending through the front frame 10 and the rear frame 20.

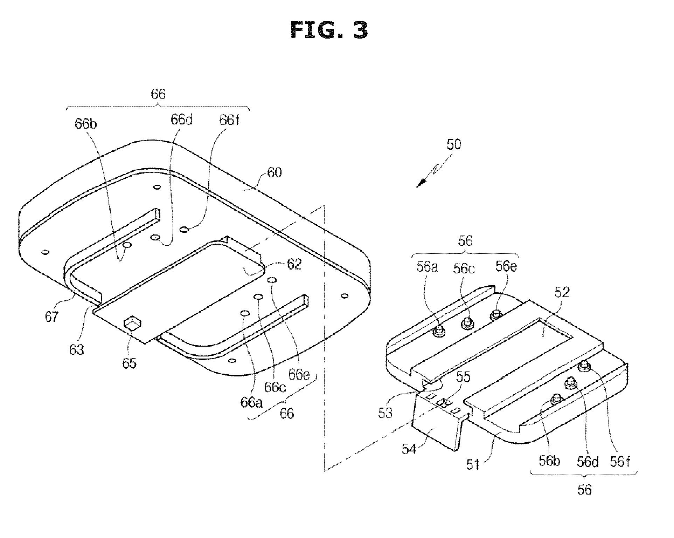

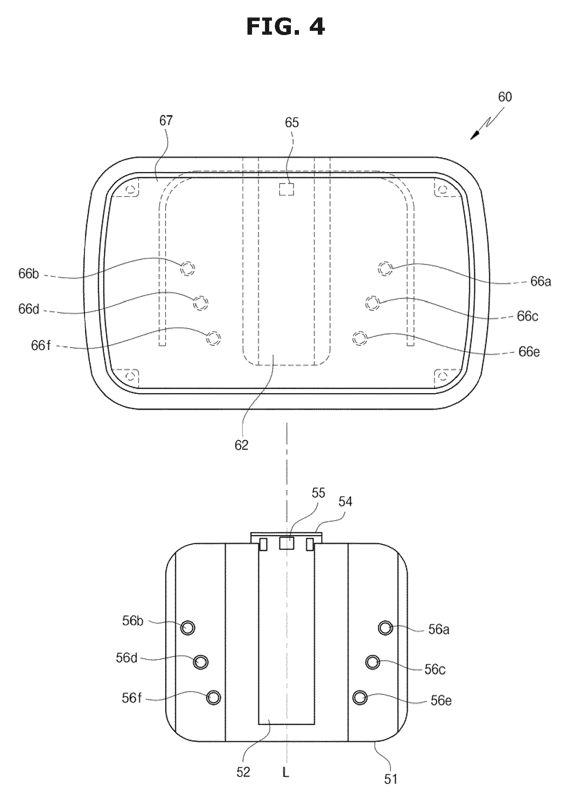

FIGS. 3 and 4 show the human machine interface in detail. Referring to FIGS. 3 and 4, the human machine interface 50 includes a stand 51 provided at the handle bar 16 and an interface body 60 slidably coupled to the stand 51.

The stand 51 is provided at the bottom thereof with a clamp (not shown) to fix the stand 51 to the handle bar 16. The stand 51 is provided at the top thereof with a first holder 52, which is coupled to the interface body 60. The first holder 52 is provided at the middle of the stand 51 in the shape of a groove extending in one direction. The first holder 52 is provided at the edge thereof with a rail groove 53. A pusher 54 is provided at the entrance of the rail groove 53 such that the pusher 54 protrudes downward from the stand 51. A catching groove 55 is provided at the pusher 54.

In addition, the stand 51 is provided at opposite sides of the top thereof with a plurality of first contact points 56 to electrically connect the interface body 60 to the electronic controller 40. Each of the first contact points 56 is formed in an elastic pin which is pushed when coupled to the interface body and protrudes when separated from the interface body. In this embodiment, the first contact points 56 include a total of six ports 56a to 56e in pairs. The first and second ports 56a and 56b are + and - of power, the third and fourth ports 56c and 56d are H and L of CAN, and the fifth and sixth ports 56e and 56f are + and - of IGN.

The display 50b is provided at the top of the interface body 60. The interface body 60 is provided at the bottom thereof with a second holder 62 coupled to the first holder 52. The second holder 62 includes a rail protrusion 63 coupled to the rail groove 53 of the first holder 52. A catching protrusion 65 corresponding to the catching groove 55 is provided at one end of the rail protrusion 63. Upon completion of sliding coupling between the interface body and the stand 51, the catching protrusion 65 is engaged into the catching groove 55. The pusher 54 may be pushed to release the coupling between the interface body and the stand 51.

In addition, the interface body 60 is provided at the bottom thereof with second contact points 66 including a total of six ports 66a to 66e in + and - pairs. In front of the second contact points 66 is provided a waterproofing well 67 to prevent introduction of rainwater to the contact points. The waterproofing well 67 protrudes while being bent to simultaneously cover the front and side of the edge of the stand 51. A short circuit between the contacts 56 and 66 due to water introduced from the outside may be prevented by the waterproofing well 67 provided at the edge of the interface body and the first holder 52 provided at the middle of the stand.

The six ports of the first contact points 52 and the second contact points 62 are arranged in a V shape. Although the ports are arranged in a V shape in this embodiment, positions of the ports may be variously changed.

The contact point pairs are arranged so as to deviate from a direction of sliding coupling between the stand 51 and the interface body 60. For example, as shown in FIG. 4, the contact point pairs may be opposite to each other with respect to a virtual line L extending in the sliding coupling direction. That is, in a case in which the first port 56a is disposed at the right side of the drawing, the second port 56b forming a pair with the first port 56a may be disposed at the left side of the drawing. In the same manner, the third port 56c and the fourth port 56d may be disposed at the right side and the left side of the drawing, respectively, and the fifth port 56e and the sixth port 56f may be disposed at the right side and the left side of the drawing, respectively. The ports 66a to 66f of the second contact points 66 are arranged in the same manner as in the ports 56a to 56f of the first contact points 56.

In addition, the ports 56a to 56f and the 66a to 66f are arranged not to overlap each other in the sliding direction. If the ports are parallel to each other in the sliding direction, electric conduction may be performed during sliding even when the coupling between the stand 51 and the interface body 60 is abnormal. To this end, the six ports may be arranged at an inclination to the sliding direction. The six ports may be arranged at a right angle to the sliding direction. In this case, however, it may be difficult to secure a space necessary to mount components forming the contact points. For this reason, the ports are arranged at an inclination to the sliding direction. In another example, if the six ports are arranged in a shape of '><' in which the first port 56a and the second port 56b are disposed at the same position and the fifth port 56e and the sixth port 56f are disposed at the same position as shown in FIG. 4, not in a shape of '↘↙', the human machine interface 50 may malfunction or may be powered off during sliding coupling.

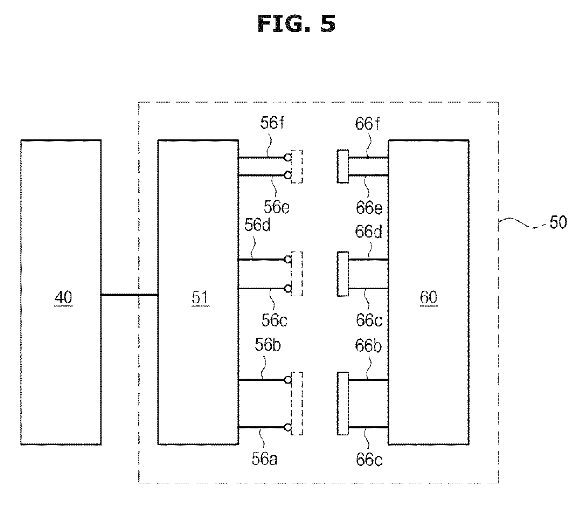

FIG. 5 is a view illustrating electrical connection between the electronic controller 40 and the human machine interface 50. When the interface body 60 is slid and coupled to the stand 51, the electronic controller 40 may transmit power and communication signals to the human machine interface 50 via the stand 51 and the interface body 60. For example, when the interface body 60 is slid and coupled to the stand 51, the first contact points 56 provided at the stand 51 are electrically connected to the second contact points 66 provided at the interface body 60. As a result, data signals of the electronic controller 40 are output to the display 50b of the interface body 60.

As is apparent from the above description, the human machine interface of the electric bicycle according to the embodiment of the present invention is mounted at the handle of the bicycle such that the user may actively control pedal feeling.

In addition, the human machine interface of the electric bicycle according to the embodiment of the present invention is configured such that the interface body is slidably coupled to the stand. Consequently, coupling and separation between the interface body and the stand are easily achieved. The contact points for power and communication do not interfere with each other during coupling. Furthermore, the contact points are disposed such that rainwater is not introduced into the contact points. Consequently, stable electric connection is achieved.

Although a few embodiments of the present invention have been shown and described, it would be appreciated by those skilled in the art that changes may be made in these embodiments within the scope of the invention.

## Claims

1. A human machine interface (50) of an electric bicycle comprising:
a stand (51) electrically connected to an electronic controller (40) of the electric bicycle, the stand comprising a plurality of first contact point pairs (56); and
an interface body (60) slidably coupled to the stand, the interface body comprising a plurality of second contact point pairs (66) electrically connected to the first contact point pairs, wherein
the first contact points or the second contact points are arranged so as to deviate from a sliding direction.

2. The human machine interface according to claim 1, wherein the first contact point pairs or the second contact point pairs are opposite to each other with respect to a virtual line extending in the sliding direction.

3. The human machine interface according to claim 1 or 2, wherein the first contact points or the second contact points are arranged at an inclination to the sliding direction.

4. The human machine interface according to any one of claims 1 to 3, wherein
the stand is provided at a top thereof with a first holder (52), and
the interface body is provided at a bottom thereof with a second holder (62) coupling to the first holder in the sliding direction.

5. The human machine interface according to any one of claims 1 to 3, wherein a waterproofing well (67) is provided in front of the second contact points.

6. The human machine interface according to claim 5, wherein the waterproofing well is provided to cover a front and side of the stand.
